# EUROPEAN PATENT SPECIFICATION

(11) **EP 0 383 743 B1**
(45) Date of publication and mention of the grant of the patent: **27.04.1994**
(21) Application number: 90850065.5
(22) Date of filing: 13.02.1990
(51) Int. Cl.: H01L 29/784

(54) **Thin film transistor**
Dünnschichttransistor
Transistor en couches minces

(30) Priority: 17.02.1989 JP 38069/89
(43) Date of publication of application: 22.08.1990
(73) Proprietor: International Business Machines Corporation, Armonk, N.Y. 10504 (US); KABUSHIKI KAISHA TOSHIBA, Kawasaki-shi, Kanagawa-ken 210 (JP)
(72) Inventor: Ikeda, Hiroyuki, Yokohama-shi, Kanagawa-ken (JP); Uchida, Teruo, Sagamihara-shi, Kanagawa-ken (JP); Shimada, Osamu, Kawasaki-shi, Kanagawa-ken (JP); Murakami, Takahiro, Kusatsu-shi, Shiga-ken (JP)
(74) Representative: Burt, Roger James, Dr.

(56) References cited:
- EP-A- 0 166 261
- PATENT ABSTRACTS OF JAPAN vol. 10, no. 259 (E-434)(2315) 04 September 1986, & JP-A-87371
- PATENT ABSTRACTS OF JAPAN vol. 10, no. 313 (E-448)(2369) 24 October 1986, & JP-A-125083
- PATENT ABSTRACTS OF JAPAN vol. 11, no. 341 (E-554)(2788) 07 November 1987, & JP-A-62 122275

## Description

This invention relates to a thin film transistor.

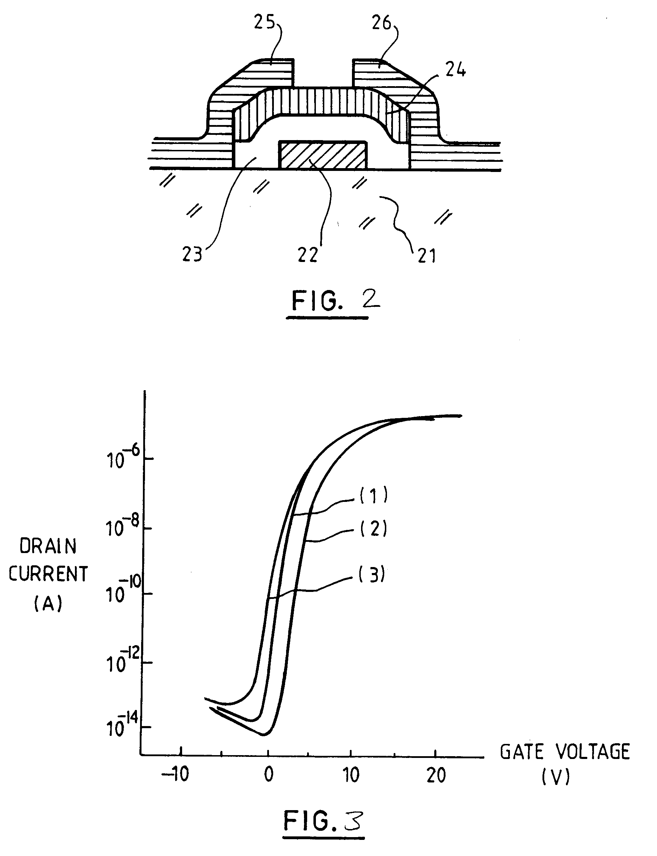

An example of a conventional amorphous silicon thin film transistor is shown in Fig.2. A transparent insulating substrate 21 is provided thereon with a gate electrode 22 using chrome (Cr), and a gate insulating layer 23 that consists of silicon nitride formed by a plasma CVD process. A semiconductor layer 24 using amorphous silicon is formed on the gate insulating layer 23, and a source electrode 25 and a drain electrode 26 are formed by aluminum (A1).

Figure 3 shows the electrical characteristics of the conventional amorphous silicon thin film transistor shown in Figure 5. The curve (1) of Figure 6 shows the drain current-gate voltage (Id-Vg) characteristics at an initial state where the voltage between the source and the drain (Vsd) was set for 10 volts. The threshold voltage (Vth) at the moment was 1.2 volts. The curve (2) of Figure 6 shows the Id-Vg characteristics after applying +25 volts to the gate voltage of this amorphous silicon thin film transistor with constant source-drain voltage (Vsd) = 10 volts, leaving it for 96 hours. The curve (3) of Figure 3 similarly shows the Id-Vg characteristics after applying -10 volts to the gate voltage and leaving for 96 hours. The threshold voltage of the curves (2) and (3) of Figure 6 is 2.1 and -0.3 volts, respectively.

As seen from Figure 3, in the conventional amorphous silicon thin film transistor with the structure of Figure 2, the threshold voltage (Vth) shifts in the positive direction when a positive potential is applied to the gate voltage and left, and in the negative direction when negative potential is applied and left. The amount of the shift is particularly significant in the positive direction. The variation of the threshold voltage (Vth) appears to be caused by the fact that electric charges are implanted in the gate insulating layer 23.

Also, a similar variation of the threshold voltage (Vth) is observed on the conventional amorphous silicon thin film transistor for temperature change. The charge implantation into the gate insulating layer 23, which appears to be the cause of those variations of the threshold voltage (Vth), is caused by the gate voltage and the source voltage/current, but mainly by the gate voltage.

As described, the variation of the threshold voltage (Vth) of the conventional amorphous silicon thin film transistor is very sensitive to external stress such as the gate voltage and temperature, which causes a very significant problem in stable operation and reliability.

The invention is made in view of the above problems, and its object is to provide a thin film transistor exhibiting high reliability and high performance while holding the variation of its threshold voltage at the minimum level.

Various approaches to improving the reliability of field effect transistor have been disclosed in the prior art. Thus in the patent Abstracts of Japan, Vol.10 No.313 (JP A 61 125083) and Vol.11 No.341 (JP A 62 122 275) there are disclosed field effect transistors using buffer layers o silicon carbide at the interface between the gate insulator and the source and drain electrodes, while in Vol.10 No.259 (JP A 61 87371) there is disclosed the use of a composite high and low conductivity amorphous silicon layer similarly to improve the interface characteristics.

Such buffer layers between the gate insulating layer and the semiconductor layer can permit the ageing variation of the threshold voltage (Vth) to be decreased, and the variations of the threshold voltage (Vth) within each production lot to be suppressed. The variation of the threshold voltage (Vth) seems to be caused by the fact that the electric charge flowing into the insulating layer or captured in an interface causes a change in the amount of the effective charge induced in the surface of the semiconductor layer. Such variation of the threshold voltage (Vth) is particularly significant when the semiconductor layer consists of amorphous material. Suppressing of the variation is also important because the amorphous semiconductor is widely used.

The buffer layer contributes to reduce the change of the amount of the effective charge induced in the surface of the semiconductor. That is, the buffer layer in place of the semiconductor layer interacts with the insulating layer so as to prevent the effective charge in the semiconductor layer from being reduced. However, buffer layers which function in the above manner typically have a carrier density higher than that of the semiconductor layer, so that it may become a path of source-drain current adversely affecting the performance of the device.

According to the invention there is provided a thin film transistor comprising a gate electrode, a gate insulating layer, a semiconductor layer, a buffer layer provided between the gate insulating layer and the semiconductor layer, a source electrode and a drain electrode, characterised in that the carrier density of said buffer layer is higher than that of said semiconductor layer and said buffer layer is separated into a source section and a drain section. Preferably a symmetrical arrangement is employed in which the gate electrode is positioned on one side of the gate insulating layer and the buffer layer of high carrier density is positioned on the other side of the gate insulating layer, while the buffer layer is positioned on one side of the semiconductor layer and the source and the drain electrodes are positioned on the other side of the semiconductor layer.

This symmetry and the high carrier density in the buffer layer enables the ageing variation of the threshold voltage to be suppressed and a high ON current between the source and the drain to be obtained because carriers are previously dispersed in the insulating layer.

FIGURE 1 is a cross section of a thin film transistor embodying the invention.

FIGURE 2 is a cross section of an example of a conventional amorphous silicon thin film transistor.

FIGURE 3 is a diagram showing the drain current-gate voltage characteristics of a thin film transistor with a conventional structure.

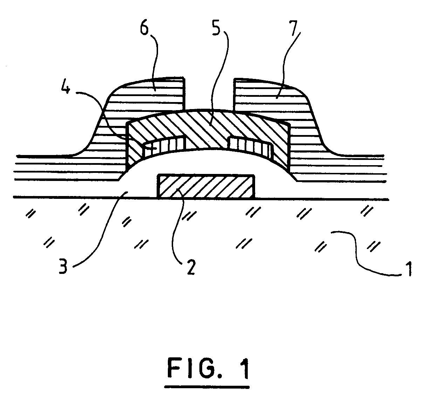

Figure 1 shows a cross section of a thin film transistor embodying the invention.

The thin film transistor according to this embodiment consists of a gate electrode 2, a gate insulating layer 3 and a semiconductor layer 5, a buffer layer 4 provided between the gate insulating layer 3 and the semiconductor layer 5, a source electrode 6 and a drain layer 7.

The gate electrode 2 is formed by chromium (Cr) in a thickness of 300 nm (3,000 angstroms) on a transparent insulating substrate 11 consisting of glass. A gate insulating layer 3 is formed on the gate electrode 2 by a silicon nitride film in a thickness of 200 nm (2,000 angstroms). After the gate insulating layer 3 is formed, the buffer layer 4 is formed by molybdenum (Mo) with a thickness of 30 nm (300 angstroms) following surface light etching of by a sputtering device. In addition, the buffer layer 4 is formed by separating into a section below the source electrode 6 and a section below the drain electrode 7.

After the surface light etching, the semiconductor layer 5 is formed on the buffer layer 4 by a phospor doped amorphous silicon (n+-a-Si) and an amorphous silicon film (a-Si) in a thickness of 200 nm (2,000 angstroms). The source electrode 6 and the drain electrode 7 are also formed on it by aluminum (A1).

The buffer layer 4 serves to reduce change of the amount of effective charge induced on the surface of the semiconductor layer 5. That is, the buffer layer 4 in place of the semiconductor layer interacts with the insulating layer 3 so as to prevent the effective charge in the semiconductor layer from being reduced. To this end, as described above, the buffer layer 4 is formed by a material having a higher carrier density than that of the semiconductor layer 5.

Furthermore, the buffer layer 4 may become a path of source-drain current, so that the buffer layer with high carrier density is separated into a section below the source electrode 6 and a section below the drain electrode 7. Then, as shown in the figure, a symmetrical arrangement is employed in which the gate electrode 2 is positioned on one side of the gate insulating layer 3 and the two sections of the buffer layer 4 are framed on the other side of the gate insulating layer 3, in the semiconductor layer 5 and aligned respectively with the source electrode 6 and the drain electrode 7, which are positioned on the other side of the semiconductor layer 5.

Here, channel width/channel length = 40 µm/10 µm.

In the above arrangement, because carriers are previously dispersed in the buffer layer 4, the ageing variation of the threshold voltage is suppressed, and high current can be obtained between the source and the drain.

As described, the invention provides a thin film transistor that can reduce the ageing variation of the threshold voltage, and can be stably driven by making the energy band gap width of the buffer provided between the gate insulating layer and the semiconductor layer wider than that of the semiconductor layer, or by making the carrier density of the buffer layer higher than that of the semiconductor layer.

In addition, higher ON current between the source and the drain can be obtained by making the carrier density of the buffer layer higher than that of the semiconductor layer, and by separating the buffer layer into the source section and the drain section.

## Claims

1. A thin film transistor comprising a gate electrode (2), a gate insulating layer (3), a semiconductor layer (5), a buffer layer (4) provided between the gate insulating layer and the semiconductor layer, a source electrode (6), and a drain electrode (7), the carrier density of said buffer layer being higher than that of said semiconductor layer, characterised in that said buffer layer is spatially separated by said semiconductor layer (5) into a source section and a drain section.

2. A transistor as claimed in Claim 1 wherein said semiconductor layer consists of amorphous silicon.

3. A transistor as claimed in claim 1 or claim 2 in which said source and drain sections are symmetrically disposed under said source and drain electrodes, respectively about a centrally disposed gate electrode.

## Patentansprüche

1. Ein Dünnschichttransistor, der eine Gatterelektrode (2), eine Gatterisolierschicht (3), eine Halbleiterschicht (5), eine Pufferschicht (4) zwischen der Gatterisolierschicht und der Halbleiterschicht, eine Source-Elektrode (6) und eine Drain-Elektrode (7) umfaßt, wobei die Trägerdichte der genannten Pufferschicht höher ist als die der Halbleiterschicht, dadurch gekennzeichnet, daß diese Pufferschicht durch die genannte Halbleiterschicht (5) räumlich in einen Source-Bereich und in einen Drain-Bereich aufgeteilt wird.

2. Ein Transistor gemäß Anspruch 1, wobei die genannte Halbleiterschicht aus amorphem Silikon besteht.

3. Ein Transistor gemäß Anspruch 1 oder Anspruch 2, wobei die genannten Source-/Drain-Bereiche symmetrisch unter den Source-bzw. Drain-Elektroden und über einer in der Mitte angeordneten Gatterelektrode angeordnet werden.

## Revendications

1. Transistor à couche mince comprenant une électrode de grille (2), une couche isolante de grille (3), une couche semiconductrice (5), une couche intermédiaire (4) disposée entre la couche isolante de grille et la couche semiconductrice, une électrode de source (6), et une électrode de drain (7), caractérisé en ce que la densité de porteurs de ladite couche intermédiaire étant supérieure à celle de ladite couche semiconductrice, ladite couche intermédiaire est séparée dans l'espace par ladite couche semiconductrice (5) en une section de source et une section de drain.

2. Transistor selon la revendication 1 dans lequel ladite couche semiconductrice consiste en silicium amorphe.

3. Transistor selon la revendication 1 ou la revendication 2 dans lequel lesdites sections de source et de drain sont disposées symétriquement sous lesdites électrodes de source et de drain, respectivement, par rapport à une électrode de grille disposée au centre.
